# EUROPÄISCHE PATENTSCHRIFT

(11) **EP 0 570 389 B1**
(45) Veröffentlichungstag und Bekanntmachung des Hinweises auf die Patenterteilung: **14.09.1994**
(21) Anmeldenummer: 92902468.5
(22) Anmeldetag: 10.01.1992
(51) Int. Cl.: G01R 19/00, G01R 31/305

(54) **VERFAHREN UND VORRICHTUNG ZUR KONTAKTLOSEN MESSUNG ELEKTRISCHER SPANNUNGEN IN EINEM MESSOBJEKT MIT EINER ISOLATOROBERFLÄCHE**
METHOD AND DEVICE FOR CONTACTLESS MEASUREMENT OF THE VOLTAGE IN AN OBJECT WITH AN INSULATING SURFACE
PROCEDE ET DISPOSITIF POUR LA MESURE SANS CONTACT DE TENSIONS ELECTRIQUES DANS UN OBJET A MESURER COMPORTANT UNE SURFACE ISOLANTE

(30) Priorität: 05.02.1991 DE 4103410
(43) Veröffentlichungstag der Anmeldung: 24.11.1993
(73) Patentinhaber: FRAUNHOFER-GESELLSCHAFT ZUR FÖRDERUNG DER ANGEWANDTEN FORSCHUNG E.V., 80636 München (DE)
(72) Erfinder: LACKMANN, Rainer, D-40239 Düsseldorf (DE); WEICHERT, Gerhard, D-44388 Dortmund (DE)
(74) Vertreter: Schoppe, Fritz, Dipl.-Ing.
(86) Internationale Anmeldenummer: DE9200014
(87) Internationale Veröffentlichungsnummer: WO9214162

(56) Entgegenhaltungen:
- US-A- 3 535 516
- US-A- 3 628 012
- US-A- 4 486 660
- US-A- 4 864 228
- E. Menzel et al.: "Electron Beam Probing of Integrated Circuits", 1985, Solid State Technology, pages 63-70
- Görlich et al.: "Capacitive Coupling Voltage Contrast", 1986, Scanning Electron Microscopy, pages 447-464, Chicago

## Beschreibung

Die vorliegende Erfindung betrifft ein Verfahren sowie eine Vorrichtung zur kontaktlosen Messung elektrischer Spannungen in einem Meßobjekt mit einer Isolatoroberfläche und mit wenigstens einem unter der Isolatoroberfläche liegenden leitenden Bereich nach dem Oberbegriff der Patentansprüche 1 bzw. 14.

Insbesondere befaßt sich die vorliegende Erfindung mit der kontaktlosen Messung von elektrischen Spannungen leitender Bereiche innerhalb von passivierten, integrierten Schaltungen als zerstörungsfreies Meßverfahren und mit einer für die Durchführung eines derartigen Verfahrens geeigneten Meßvorrichtung.

Verfahren und Vorrichtungen zur kontaktlosen Messung elektrischer Spannungen innerhalb von integrierten Schaltungen mit passivierten Oberfläche der oben genannten Art sind beispielsweise bekannt aus der Fachveröffentlichung E.Menzel, R.Buchanan "Electron Beam Probing of Integrated Circuits" Solid State Technology, Dezember 1985, Seiten 63 bis 70. Die für die Durchführung des bekannten kontaktlosen Spannungsmeßverfahrens verwendete Meßanordnung besteht aus einem modifizierten Rasterelektronenmikroskop und einer elektronischen Steuereinheit. Die zu untersuchende integrierte Schaltung befindet sich in einer evakuierten Meßkammer. Eine Primärelektronenstrahlerzeugungsvorrichtung richtet in der sogenannten Punktbetriebsweise (Spotmodus) einen Primärelektronenstrahl auf die Oberfläche der integrierten Schaltung. Als Folge dieser Strahlung werden Sekundärelektronen aus der Oberfläche der integrierten Schaltung ausgelöst, deren Energie vom Potential des Meßortes in der integrierten Schaltung abhängt. Mit Hilfe eines Spektrometers wird die Energie der Sekundärelektronen gemessen. Aus der gemessenen Energie der Sekundärelektronen kann auf die Spannung am Meßort rückgeschlossen werden. Bei der praktischen Anwendung dieses bekannten Meßverfahrens sowie dieser bekannten Meßvorrichtung ergeben sich jedoch verschiedene Meßfehler. Eine wesentliche Ursache dieser Meßfehler ist der sogenannte Trajektorienkontrast, welcher durch eine inhomogene Feldverteilung über den Leiterbahnen der integrierten Schaltung hervorgerufen wird. Die Ursache hierfür kann beispielsweise in einem Übersprechen der Signale von Bonddrähten oder von einer Nachbarleiterbahn liegen.

Um die durch den Trajektorienkontrast bedingten Meßfehler zu vermindern, ist es gleichfalls bekannt, sich eines oberhalb der integrierten Schaltung angeordneten Saugnetzes zu bedienen, das mit einer hohen positiven Spannung in der Größenordnung von 1000 bis 2000 Volt belegt wird.

Aus der Fachveröffentlichung S. Görlich, K.D. Herrmann, W. Reiners, E. Kubalek "Capacitive Coupling Voltage Contrast" Scanning Electron Microscopy, 1986, II, Seiten 447 bis 464 ist es bereits bekannt, das oben beschriebene Prinzip der kontaktlosen Spannungsmessung auch bei solchen integrierten Schaltungen einzusetzen, die zum Schutz mit einer glasähnlichen Passivierungsschicht überzogen sind. Diese Passivierungsschicht bildet eine die leitenden Bereiche der integrierten Schaltung überdeckende Isolatoroberfläche. Bei Anwendung des oben beschriebenen Meßverfahrens auf passivierte, integrierte Schaltungen erfolgt die Generation von Sekundärelektronen auf der Isolatoroberfläche. Die Messung der Potentiale der leitenden Bereiche unterhalb der Isolatoroberfläche wird durch eine kapazitive Kopplung zwischen den leitenden Bereichen und der Isolatoroberfläche der Passivierungsschicht ermöglicht.

Ausgehend von diesem Stand der Technik liegt der vorliegenden Erfindung die Aufgabe zugrunde, ein Verfahren sowie eine Vorrichtung der eingangs genannten Art so weiterzubilden, daß elektrische Spannungen innerhalb von Meßobjekten mit einer Isolatoroberfläche mit höherer Genauigkeit gemessen werden können.

Der in den Ansprüchen 1 und 14 definierten Erfindung liegt die Erkenntnis zugrunde, daß auch bei Anwendung des kontaktlosen Spannungsmeßverfahrens bzw. der kontaktlosen Spannungsmeßvorrichtung der eingangs beschriebenen Art auf Meßobjekte mit Isolatoroberfläche, insbesondere auf passivierte, integrierte Schaltungen, es keineswegs erforderlich ist, die Saugspannung zur Verhinderung von störenden Aufladungen auf der Passivierungsoberfläche so weit zu reduzieren, daß hierdurch zwangsläufig Meßfehler aufgrund des Trajektorienkontrastes auftreten müssen, wenn man sich davon löst, daß die an das Saugnetz angelegte Saugspannung einen konstanten Wert zu haben hat, wie dies im Stand der Technik vorausgesetzt wird.

Nach einer bevorzugten Ausgestaltung des erfindungsgemäßen Verfahrens sowie der erfindungsgemäßen Vorrichtung wird mit rechteckförmig verlaufenden elektrischen Saugfeldern gearbeitet, die durch eine zeitlich rechteckförmige Saugnetzspannung hervorgerufen werden. Vorzugsweise wechseln die Spannungen am Saugnetz zwischen hohen positiven Spannungen in der Größenordnung von 1 bis 2 kV während eines ersten Periodendauerabschnittes und einer- zweiten, niedrigen negativen Spannung in der Größenordnung von -1 bis -100 V, wobei die Periodendauer derart gewählt ist, daß sie kleiner als die Umladezeitkonstante für die Oberflächenladung der Passivierungsschicht der integrierten Schaltung ist.

Bei dem erfindungsgemäßen Meßverfahren und der erfindungsgemäßen Meßvorrichtung wird die Signalauswertung nur während Teilperioden der Periode der Saugspannung vorgenommen, während denen die hohe, positive Spannung am Saugnetz anliegt. Hierdurch erreicht die Erfindung eine starke Reduktion der Meßfehler aufgrund des Trajektorienkontrastes, obwohl eine Aufladung der Passivierungsoberfläche der integrierten Schaltung verhindert wird.

Bevorzugte Weiterbildungen des erfindungsgemäßen Verfahrens sowie der erfindungsgemäßen Vorrichtung sind in den Unteransprüchen angegeben.

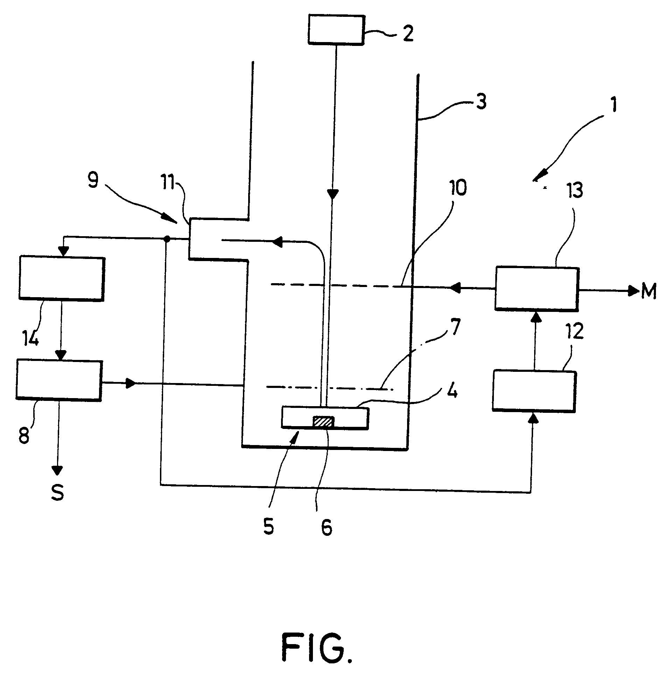

Nachfolgend wird unter Bezugnahme auf die beiliegende Zeichnung eine bevorzugte Ausführungsform einer erfindungsgemäßen Meßvorrichtung näher erläutert. Es zeigt:
- Die einzige Figur:: eine schematische Darstellung einer Ausführungsform einer erfindungsgemäßen Vorrichtung zur kontaktlosen Messung elektrischer Spannungen innerhalb eines Meßobjektes mit einer Isolatoroberfläche.

Wie in der einzigen Figur gezeigt ist, umfaßt die Vorrichtung zur kontaktlosen Messung elektrischer Spannungen, die in ihrer Gesamtheit mit dem Bezugszeichen 1 bezeichnet ist, eine Primärstrahlerzeugungsvorrichtung 2, die innerhalb einer evakuierten Meßkammer 3 einen Primärelektronenstrahl auf eine Isolatoroberfläche in Form einer Passivierungsschicht 4 einer integrierten Schaltung 5 richtet, wobei der Auftreffort des Primärelektronenstrahles auf der Passivierungsschicht 4 oberhalb eines bezüglich seiner Spannung zu messenden, leitenden Bereiches 6 der integrierten Schaltung 5 liegt. Oberhalb der integrierten Schaltung 5, d.h. in Richtung des einfallenden Primärstrahles von der Oberfläche der integrierten Schaltung 5 beabstandet, liegt ein Saugnetz 7, das mit einer Saugspannung von einer Saugspannungsquelle 8 beaufschlagt wird. Ein an der Oberfläche der Passivierungsschicht 4 durch den auftreffenden Primärelektronenstrahl generierter Sekundärelektronenstrom wird durch eine Vorrichtung 9 zur Messung der Energie der Elektronen des Sekundärelektronenstromes ausgewertet. Bei dem gezeigten, bevorzugten Ausführungsbeispiel ist diese Energiemeßvorrichtung 9 als Spektrometer ausgeführt und umfaßt ein Bremsgitter 10 sowie einen Detektor 11. Das Bremsgitter 10 dient zur Energieselektion der Sekundärelektronen, da es nur Sekundärelektronen von hinreichend hoher Energie zu dem Detektor 11 durchläßt. Das Detektorsignal wird über einen Hochpaß 12 zu einer Reglervorrichtung 13 zugeführt, die die Bremsgitterspannung derart nachregelt, daß die Spektrometercharakteristik linearisiert wird. Sowohl der Hochpaß 12 wie auch die Reglervorrichtung 13 sind an sich in Verbindung mit derartigen Spannungsmeßvorrichtungen 1 bekannt, so daß eine detaillierte Erläuterung der Struktur dieser Komponenten entfallen kann. Die Reglervorrichtung 13 erzeugt ausgangsseitig ferner ein Meßsignal M, welches von der Energie der Sekundärelektronen abhängt und somit ein Maß für die Spannung des bezüglich seiner Spannung zu messenden leitenden Bereiches 6 ist.

Das Detektorsignal wird ferner einem Tiefpaß 14 zugeführt, der den zeitlichen Mittelwert des Detektorausgangssignales für die Zeiten positiver Saugspannung bildet.

Die Saugspannungsquelle 8 ist als Rechteckspannungsquelle ausgeführt. Die Ausgangsspannung der Saugspannungsquelle 8 wechselt zwischen einer hohen positiven Spannung von 1 bis 2 kV und einer niedrigen negativen Spannung zwischen -1 Volt und -100 Volt. Während des Periodenteiles der Erzeugung der hohen positiven Spannung werden fast alle Sekundärelektronen abgesaugt. Dies führt zu einer positiven Aufladung der Oberfläche der Passivierungschicht 4 der integrierten Schaltung 5 mit der Umladezeitkonstante ihrer Oberflächenladungen, die im Bereich zwischen einer Millisekunde und etwa einer Sekunde liegen kann.

Während des Periodenanteiles der Erzeugung der niedrigen negativen Spannung kehren fast alle Sekundärelektronen wiederum zur Oberfläche der Passivierungsschicht 4 zurück, so daß der positive Ladungsüberschuß wieder abgebaut wird. Die Periodendauer der Rechteck-Saugspannungsquelle 8 ist derart gewählt, daß sie kleiner als die Umladezeitkonstante für die Oberflächenladung ist. Auf diese Weise können die zeitlichen Schwankungen des Oberflächenpotentiales hinreichend klein gehalten werden.

Mit dem Ausgangssignal vom Tiefpaß 14 erfolgt eine Regelung des Verhältnisses der Zeitdauer der Erzeugung der hohen positiven Spannung bzw. der niedrigen negativen Spannung in der Weise, daß sich im zeitlichen Mittel ein niedriges, positives Oberflächenpotential an der Passivierungsschicht 4 der integrierten Schaltung 5 einstellt.

Die Rechteck-Saugspannungsquelle 8 erzeugt ferner jeweils mit dem Zeitpunkt des Anlegens der hohen positiven Spannung an das Saugnetz 7 ein Synchronisationssignal S, mittels dessen die Auswertung des Meßsignales M durch eine (nicht gezeigte) Auswertungsvorrichtung jeweils auf die Zeiten des hohen Saugpotentials beschränkt wird.

Somit wird die Messung der Energie der Sekundärelektronen lediglich während Zeiten durchgeführt, während denen eine hohe positive Spannung am Saugnetz anliegt, so daß Fehler durch den Trajektorienkontrast minimiert werden.

Der Primärelektronenstrahl wird auch während der Zeiten der Absenkung der Saugnetzspannung auf die niedrige, negative Spannung unverändert erzeugt. Jedoch wird die Signalauswertung des Meßsignales M während dieser Zeiten unterbrochen.

Zusätzlich kann die Isolatoroberfläche 4 des Meßobjektes zum Ausgleich der in der Meßphase ausgebildeten Oberflächenladungen während der Kompensationsphase flächig bestrahlt werden. Unter der Meßphase sei hier diejenige Zeit verstanden, während der das Saugfeld innerhalb seines ersten Teiles der Periode eine hohe Feldstärke mit einer die Sekundärelektronen von- der Isolatoroberfläche des Meßobjektes absaugenden Polarität hat. Während dieser Zeitdauer wird der Primärelektronenstrahl zur Messung im Punktmodus betrieben. Als Kompensationsphase sei die Zeitdauer des zweiten Teiles der Periode des Saugfeldes verstanden, während der das Saugfeld die Sekundärelektronen zu der Isolatoroberfläche 4 des Meßobjektes 5 zurücktreibt. Da durch die Änderung der Saugspannung der Primärelektronenstrahl während der Kompensationsphase nicht auf die Isolatoroberfläche 4 des Meßobjektes 5 fokussiert ist, wird bereits durch die Veränderung der Saugspannung eine Vergrößerung des Ortes der Einstrahlung während der Kompensationsphase erzielt. Zusätzlich kann jedoch die Größe und Lage der bestrahlten Fläche durch eine rasterförmige Ablenkung des Primärelektronenstrahles während der Kompensationsphase, d.h. während des zweiten Teiles der Periode des Saugfeldes, beeinflußt werden, um die örtliche Ladungsverteilung auf der Isolatoroberfläche 4 des Meßobjektes 5 gezielt zu beeinflussen.

Durch Steuerung der Verweildauer des Primärelektronenstrahles, des Strahlstromes oder der Rasterfläche kann eine derartige örtlich inhomogene Verschiebung des Oberflächenpotentiales an der Isolatoroberfläche 4 des Meßobjektes 5 erreicht werden, daß der Auftreffpunkt des Primärelektronenstrahles während der Meßphase, d.h. des ersten Teiles der Periode des Saugfeldes, innerhalb des Bereiches liegt, in dem die Sekundärelektronen während der Kompensationsphase, d.h. während des zweiten Teiles der Periode des Saugfeldes, retardiert werden. Hierdurch kann die Aufladung gesteuert werden.

In Abweichung von der soeben beschriebenen Steuerung bzw. Kompensation der Oberflächenladungen durch Variation der Primärelektronenbestrahlung ist es gleichfalls möglich, eine gezielte Ablenkung der Sekundärelektronen während des jeweiligen zweiten Teiles der Periode des Saugfeldes, d.h. während der Kompensationsphase, vorzunehmen. Ebenso wie bei der zuerst beschriebenen Maßnahme kann erreicht werden, daß der während des ersten Teiles der Periode des Saugfeldes, d.h. während der Meßphase, bestrahlte Bereich während des zweiten Teiles der Periode des Saugfeldes, d.h. während der Kompensationsphase von einer ausreichenden Sekundärelektronenanzahl getroffen wird. Die Flugbahn der Sekundärelektronen kann durch geeignete Beeinflussung der Form und Stärke des Saugfeldes gesteuert werden. Zur Feldformung kann einerseits eine geeignete Formung des Saugnetzes 7 beispielsweise in hemisphärischer Ausbildung beitragen. Gleichfalls ist es möglich, unterhalb des Saugnetzes 7 zusätzliche elektrostatische Ablenkelektroden vorzusehen, die beispielsweise als segmentierte Elektroden oder mechanisch justierbare, zusätzliche Ringelektroden ausgestaltet sein können.

Die zur Kompensation der Aufladungen benötigte Zeitspanne ist unter anderem vom zeitlichen Mittel des Primärelektronenstrahlstromes in der Kompensationsphase, d.h. während des zweiten Teiles der Periode des Saugfeldes, abhängig. Die erforderliche Zeitdauer zur Kompensation der Aufladungen kann reduziert werden, indem der mittlere Primärelektronenstrahlstrom während der Kompensationsphase, d.h. des zweiten Teiles der Periode des Saugfeldes, gegenüber der Meßphase, d.h. des ersten Teiles der Periode des Saugfeldes, erhöht wird. Insbesondere kann dies bei stroboskopischen Messungen durch die Änderung des Tastverhältnisses erfolgen, welches zwischen dem ausgetasteten Strahl und dem auf die Probe auftreffenden Primärelektronenstrahl eingestellt wird. Mit einer derartigen Intensitätsmodulation des Primärelektronenstrahles kann eine sehr kurze Kompensationsphase erreicht werden, wodurch bei der Messung im Rastermodus die Beobachtung des Meßobjektes 5 in Form einer Schaltung vereinfacht wird und im Punktmodus die Meßzeit reduziert wird.

Grundsätzlich kann die Intensitätsregelung des Primärelektronenstrahles während des Kompensationsphase auch zur Regelung der Ladungskompensation verwendet werden, indem in Abhängigkeit von der Verschiebung des Oberflächenpotentiales der Isolatoroberfläche 4 während der Kompensationsphase ein mehr oder weniger großer Primärelektronenstrahl zu dem Meßobjekt 5 zugeführt wird. Auf diese Weise kann eine konstante Dauer der Kompensationsphase vorgegeben werden, um Synchronisationsvorgänge während der Messung zu erleichtern. Ferner ist es möglich, die bei flächiger Bestrahlung des Meßobjektes 5 in der Kompensationsphase beabsichtigte örtliche Veränderung des Oberflächenpotentiales durch eine derartige Intensitätsmodulation des Primärelektronenstrahles zu unterstützen.

Die Regelung des Aufladungszustandes der Isolatoroberfläche 4 des Meßobjektes 5 kann in Abweichung zu diesen Varianten auch durch Veränderung der während des zweiten Teiles der Periode verwendeten Spannung am Saugnetz 7 erfolgen. Der Arbeitspunkt einer derartigen Saugfeldregelung wird derart gewählt, daß nur ein Teil der Sekundärelektronen während des zweiten Teiles der Periode des Saugfeldes retardiert wird. Durch Variation der Saugfeldspannung während des zweiten Teiles der Periode kann der Anteil der retardierten Sekundärelektronen beeinflußt werden. Bei einer Verschiebung des Oberflächenpotentiales ergibt sich eine entgegengesetzte Verschiebung des Anteils der retardierten Sekundärelektronen aufgrund der veränderten Potentialdifferenz zwischen dem Saugnetz 7 und der Probenoberfläche. Dieses Regelverfahren führt zu einer zusätzlichen, selbständigen Stabilisierung des Oberflächenpotentiales des Meßobjektes 5.

Bei dem eingangs beschriebenen, bevorzugten Meßverfahren wird ein hochpassgefiltertes Sekundärelektronensignal zur Regelung der gegenfeldnetzspannung eingesetzt, während der niederfrequente Anteil des Sekundärelektronenstrahles zur Regelung des Oberflächenpotentiales des Meßobjektes 5 verwendet wird.

Kommt es zu einer langsamen Verschiebung des Potentiales der Meßstelle beispielsweise aufgrund einer Störung des Ausgleichs von Oberflächenladungen oder aufgrund einer Abänderung des Arbeitspunktes der Regelschleife zur Ladungskompensation, so verschiebt sich das zeitliche Mittel der Spannung zwischen dem Gegenfeldnetz 10 und dem Meßobjekt 5. Aufgrund dieser Verschiebung entfernt sich der Arbeitspunkt eines Gegenfeldspektrometers von seinem optimalen Arbeitspunkt bezogen auf die Energieverteilung der Sekundärelektronen. Zusätzlich wird daher vorgeschlagen, den niederfrequenten Anteil des Sekundärelektronensignales in eine beispielsweise rechnergesteuerte Regelung einzubeziehen, die bei Auftreten einer derartigen Störung den zeitlichen Mittelwert der Gegenfeldspannung nachführt, sobald der Arbeitspunkt des Gegenfeldspektrometers sich zu weit von seinem optimalen Arbeitspunkt bezogen auf die Energieverteilung der Sekundärelektronen entfernt.

Die relativ großen Zeitkonstanten bei einer Änderung des Oberflächenpotentiales erlauben es, eine auf diese Weise erzeugte Verschiebung des Mittelwertes der Spannung am Gegenfeldnetz 10 durch Mittelung über mehrere Meßperioden oder durch eine nachfolgende analoge Filterung oder digitale Nachverarbeitung des Meßsignales aus dem Meßsignal zu entfernen.

Gleichfalls ist es möglich, eine Kombination der oben aufgeführten Regelungsmöglichkeiten zum Ausgleich der Oberflächenladungen vorzusehen, um den Ausregelungsvorgang unter Berücksichtigung der verschiedenen Meßmodi zu optimieren.

Eine Änderung des Primärelektronenstrahlstromes infolge einer Störung der Elektronenoptik oder der Strahlerzeugung führt zu einer Änderung des das Meßobjekt 5 verlassenden Sekundärelektronenstromes. Eine langsame Variation des Strahles der Primärelektronen, wie sie gelegentlich bei der Messung vorkommen kann, wird von der Regelung als Verschiebung des Oberflächenpotentiales interpretiert. Um eine unerwünschte Nachregelung des Sekundärelektronensignales zu verhindern, die zu einer unerwünschten Verschiebung des Arbeitspunktes des Gegenfeldspektrometers führen würde, kann eine Information über die Schwankung des Primärelektronenstromes in die Regelung einbezogen werden. Als Maß für den Primärelektronenstrahlstrom kann zum Beispiel der von einer Sprühblende im Strahlengang aufgefangene Strom verwendet werden. Unter Verwendung dieses Signales kann das gemessene Sekundärelektronensignal so korrigiert werden, daß der Einfluß auf den Arbeitspunkt des Gegenfeldspektrometers und auf das Potential der Meßobjektoberfläche weitgehend reduziert wird.

Das erfindungsgemäße Meßverfahren wurde unter Bezugnahme auf Messungen an integrierten Schaltungen mit einer Passivierungsschicht erläutert. Jedoch eignen sich das erfindungsgemäße Meßverfahren und die erfindungsgemäße Meßvorrichtung auch für die Messung von anderen Meßobjekten mit einer Isolatoroberfläche, unter der ein bezüglich seiner Spannung zu messender leitender Bereich angeordnet ist.

## Patentansprüche

1. Verfahren zur kontaktlosen Messung elektrischer Spannungen in einem Meßobjekt (5) mit einer Isolatoroberfläche (4) und wenigstens einem unter der Isolatoroberfläche (4) liegenden leitenden Bereich (6), insbesondere in einer integrierten Schaltung (5) mit passivierter Oberfläche, bei dem:
- ein Primärelektronenstrahl in einer evakuierten Meßkammer (3) auf die Isolatoroberfläche (4) oberhalb des bezüglich seiner Spannung zu messenden leitenden Bereiches (6) des Meßobjektes (5) gerichtet wird;
- ein Sekundärelektronenstrom an der Isolatoroberfläche (4) des Objektes (5) generiert wird;
- ein elektrisches Saugfeld oberhalb des Meßobjektes (5) erzeugt wird; und
- das Potential des leitenden Bereiches (6) durch Messung der Energie der Elektronen des Sekundärelektronenstromes ermittelt wird,
dadurch gekennzeichnet,
daß das elektrische Saugfeld ein Wechselfeld ist, das zwischen einer positiven und einer negativen Spannung wechselt, wobei die positive Spannung dem Betrage nach hoch, verglichen mit der negativen Spannung, ist, und
daß die Messung der Energie der Elektronen des Sekundärelektronenstromes in Synchronisation mit derjenigen Teilperiode des Wechselfeldes erfolgt, in der die hohe, positive Saugspannung anliegt.

2. Verfahren nach Anspruch 1, dadurch gekennzeichnet,
daß das Saugfeld eine Periodendauer aufweist, die geringer als die Umladezeitkonstante für Oberflächenladungen an der Isolatoroberfläche (4) des Meßobjektes (5) ist.

3. Verfahren nach Anspruch 1 oder 2, dadurch gekennzeichnet,
daß das Saugfeld einen rechteckförmigen zeitlichen Verlauf hat,
daß das Saugfeld während eines ersten Teiles der Periode eine hohe Feldstärke mit einer die Sekundärelektronen von der Isolatoroberfläche (4) des Meßobjektes (5) absaugenden Polarität hat, und
daß das Saugfeld während des zweiten Teiles der Periode eine, verglichen mit der Feldstärke während des ersten Teiles der Periode, niedrige Feldstärke mit einer die Sekundärelektronen zu der Isolatoroberfläche (4) des Meßobjektes (5) zurücktreibenden Polarität hat.

4. Verfahren nach Anspruch 3, dadurch gekennzeichnet,
daß das Verhältnis des ersten Periodenteiles zu dem zweiten Periodenteil derart in Abhängigkeit von dem Oberflächenpotential der Isolatoroberfläche (4) des Meßobjektes (5) geregelt wird, daß sich im zeitlichen Mittel ein niedriges Oberflächenpotential an der Isolatoroberfläche (4) des Meßobjektes (5) einstellt.

5. Verfahren nach Anspruch 4, dadurch gekennzeichnet,
daß der Betrag der zeitlich mittleren Oberflächenpotentiale zwischen null Volt und zehn Volt liegt.

6. Verfahren nach Anspruch 3 oder 4, dadurch gekennzeichnet,
daß der Primärelektronenstrahl während des ersten Teiles der Periode des Saugfeldes zur Messung der elektrischen Spannung in dem Meßobjekt (5) auf dessen Isolatoroberfläche (4) fokussiert wird, und
daß der Primärelektronenstrahl während des zweiten Teiles der Periode zur Unterstützung des Ausgleichs der in der Meßphase ausgebildeten Oberflächenladungen auf der Isolatoroberfläche (4) flächig auf diese eingestrahlt wird.

7. Verfahren nach Anspruch 6, dadurch gekennzeichnet,
daß die Größe und Lage der durch den Primärelektronenstrahl während des zweiten Teiles der Periode des Saugfeldes bestrahlten Isolatoroberfläche (4) durch rasterförmige Ablenkung des Primärelektronenstrahles gesteuert werden.

8. Verfahren nach Anspruch 6 oder 7, dadurch gekennzeichnet,
daß durch Steuerung der Verweildauer oder des Stromes oder der Rasterfläche des flächigen Primärelektronenstrahles während des zweiten Teiles der Periode des Saugfeldes eine örtlich inhomogene Verschiebung des Oberflächenpotentiales der Isolatoroberfläche (4) in der Weise bewirkt wird, daß der Auftreffpunkt des punktförmigen Primärelektronenstrahles während des ersten Teiles der Periode innerhalb eines Bereiches liegt, in dem die Sekundärelektronen während des zweiten Teiles der Periode retardiert werden.

9. Verfahren nach Anspruch 3, dadurch gekennzeichnet,
daß eine Kompensation der Oberflächenladungen der Isolatoroberfläche (4) des Meßobjektes (5) durch eine derartige Beeinflussung der Flugbahnen der Sekundärelektronen durch die Form und/oder die Stärke des Saugfeldes während des zweiten Teiles der Periode vorgenommen wird, daß der während des ersten Teiles der Periode von dem Primärelektronenstrahl bestrahlte Bereich während des zweiten Teiles der Periode von einer ausreichenden Anzahl von Sekundärelektronen getroffen wird.

10. Verfahren nach Anspruch 9, dadurch gekennzeichnet,
daß die Formung des Saugfeldes während des zweiten Teiles der Periode mittels eines hemisphärisch geformten Saugnetzes (7) oder durch zusätzlich unterhalb eines ebenen Saugnetzes (7) angeordnete, elektrostatische Ablenkelektroden vorgenommen wird.

11. Verfahren nach einem Ansprüche 3 bis 10, dadurch gekennzeichnet,
daß der mittlere Strahlstrom des Primärelektronenstrahles während des zweiten Teiles der Periode des Saugfeldes gegenüber der mittleren Stärke des Strahlstromes des Primärelektronenstrahles während des ersten Teiles der Periode des Saugfeldes erhöht ist.

12. Verfahren nach Anspruch 11, dadurch gekennzeichnet,
daß der Primärelektronenstrahl während des zweiten Teiles der Periode des Saugfeldes in Abhängigkeit von der Verschiebung des Potentiales der Isolatoroberfläche (4) geregelt wird.

13. Verfahren nach Anspruch 3, dadurch gekennzeichnet,
daß die Saugfeldspannung während des zweiten Teiles der Periode in Abhängigkeit von dem Oberflächenpotential der Isolatoroberfläche (4) des Meßobjektes (5) derart geregelt wird, daß nur ein Teil der Sekundärelektronen retardiert wird.

14. Vorrichtung zur kontaktlosen Messung elektrischer Spannungen in einem Meßobjekt (5) mit einer Isolatoroberfläche (4) und wenigstens einem unter der Isolatoroberfläche (4) liegenden leitenden Bereich (6), insbesondere in einer integrierten Schaltung (5) mit passivierter Oberfläche, mit folgenden Merkmalen:
- einer Primärstrahlerzeugungsvorrichtung (2), die innerhalb einer evakuierten Meßkammer (3) einen Primärelektronenstrahl auf die Isolatoroberfläche (4) des Meßobjektes (5) oberhalb des bezüglich seiner Spannung zu messenden leitenden Bereiches (6) richtet;
- einem oberhalb des Meßobjektes (5) angeordneten Saugnetz (7), das mittels einer Saugspannungsquelle (8) mit einer Saugspannung zur Erzeugung eines Saugfeldes im Bereich oberhalb des Meßobjektes (5) beaufschlagt wird; und
- einer Vorrichtung (9) zur Messung der Energie der Elektronen eines Sekundärelektronenstromes, der an der Isolatoroberfläche (4) des Meßobjektes (5) generiert wird,
dadurch gekennzeichnet,
daß die Saugspannungsquelle (8) eine Wechselspannungsquelle ist, deren Ausgangsspannung zwischen einer positiven und einer negativen Spannung wechselt, wobei die positive Spannung dem Betrage nach hoch, verglichen mit der negativen Spannung, ist, und
daß die Meßvorrichtung (9) die Energie der Elektronen des Sekundärelektronenstromes in Synchronisation mit derjenigen Teilperiode der von der Saugspannungsquelle (8) erzeugten Wechselspannung mißt, in der die hohe, positive Saugspannung anliegt.

15. Vorrichtung nach Anspruch 14, dadurch gekennzeichnet,
daß die Saugspannungsquelle (8) eine Rechteckspannungsquelle ist.

16. Vorrichtung nach Anspruch 15, dadurch gekennzeichnet,
daß die periodendauer des von der Saugspannungsquelle (8) erzeugten rechteckförmigen spannungssignales kürzer als die Umladezeitkonstante für Oberflächenladungen an der Isolatoroberfläche (4) des Meßobjektes (5) ist.

17. Vorrichtung nach Anspruch 15 oder 16, dadurch gekennzeichnet,
daß das von der Saugspannungsquelle (8) erzeugte, zeitlich rechteckförmige Spannungssignal während eines ersten Teiles der Periode die hohe, positive Spannung gegenüber dem Potential leitender Bereiche des Meßobjektes (5) hat, und
daß das Spannungssignal während des zweiten Teiles der Periode die niedrige, negative Spannung aufweist.

18. Vorrichtung nach Anspruch 17, dadurch gekennzeichnet,
daß die hohe, positive Spannung zwischen 1000 und 2000 Volt beträgt, und
daß die niedrige, negative Spannung zwischen -1 und -100 Volt beträgt.

19. Vorrichtung nach einem der Ansprüche 14 bis 18, dadurch gekennzeichnet,
daß der Vorrichtung (9) zur Messung der Energie der Elektronen des Sekundärelektronenstromes ein Tiefpaß (14) nachgeschaltet ist, und
daß das Verhältnis der rechteckförmigen Spannung, die von der Saugspannungsquelle (8) erzeugt wird, in Abhängigkeit von dem Ausgangsignal des Tiefpasses (14) derart geregelt wird, daß sich ein niedriges, positives Oberflächenpotential an der Isolatoroberfläche (4) des Meßobjektes (5) einstellt.

## Claims

1. A method for contactless measurement of electric voltages in a unit under measurement (5) including an insulating surface (4) and at least one conducting zone (6) lying below said insulating surface (4), especially in an integrated circuit (5) having a passivated surface, wherein
- a primary electron beam is directed in an evacuated measuring chamber (3) onto the insulating surface (4) above the zone (6) of the unit under measurement (5) which is to be measured with respect to its voltage;
- a secondary electron flow is generated at the insulating surface (4) of said unit (5);
- an electric absorption field is generated above the unit under measurement (5); and
- the potential of the conducting zone (6) is determined by measuring the energy of the electrons of the secondary electron flow,
characterized in
that the electric absorption field is an alternating field which alternates between a positive voltage and a negative voltage, wherein the value of the positive voltage is high when compared to the value of the negative voltage, and
that the measurement of the energy of the electrons of the secondary electron flow is carried out in synchronism with that partial period the alternating field during which the high positive voltage is applied.

2. A method according to claim 1, characterized in
that the absorption field has a period duration which is smaller than the charge reversal time constant for surface charges at the insulating surface (4) of the unit under measurement (5).

3. A method according to claim 1 or 2, characterized in
that the absorption field has a rectangular variation with time,
that, during a first part of the period, the absorption field has a high field strength with a polarity absorbing the secondary electrons from the insulating surface (4) of the unit under measurement (5), and
that, during the second part of the period, the absorption field has, in comparison with the field strength during the first part of the period, a low field strength with a polarity driving the secondary electrons back to the insulating surface (4) of the unit under measurement (5).

4. A method according to claim 3, characterized in
that the ratio of the first part of the period to the second part of the period is controlled in response to the surface potential of the insulating surface (4) of the unit under measurement (5) in such a way that, in the time average, a low surface potential will occur at the insulation surface (4) of the unit under measurement (5).

5. A method according to claim 4, characterized in
that the values of the time-average surface potentials lie between 0 volt and 10 volt.

6. A method according to claim 3 or 4, characterized in
that, during the first part of the period of the absorption field, the primary electron beam is focussed onto the insulating surface (4) of the unit under measurement (5) for measuring the electric voltage in said unit under measurement (5), and
that, during the second part of the period, the primary electron beam is caused to fall areawise on the insulating surface (4) for supporting the equalization of the surface charges formed on said insulating surface (4) in the measurement phase.

7. A method according to claim 6, characterized in
that the size and the position of the insulating surface (4) irradiated with the primary electron beam during the second part of the period of the absorption field are controlled by rasterlike deflection of the primary electron beam.

8. A method according to claim 6 or 7, characterized in
that, by controlling the dwell time, or the flow, or the raster area of the wide primary electron beam during the second part of the period of the absorption field, a locally inhomogeneous shift of the surface potential of the insulating surface (4) will be effected in such a way that, during the first part of the period, the point of impingement of the point-shaped primary electron beam lies within an area in which the secondary electrons will be retarded during the second part of the period.

9. A method according to claims 3, characterized in
that a compensation of the surface charges of the insulating surface (4) of the unit under measurement (5) is effected by influencing the trajectories of the secondary electrons by the shape and/or the strength of the absorption field during the second part of the period in such a way that the area irradiated during the first part of the period by the primary electron beam is hit by a sufficient number of secondary electrons during the second part of the period.

10. A method according to claim 9, characterized in
that the shaping of the absorption field is carried out during the second part of the period by means of a hemispherically shaped absorption net (7) or by electrostatic deflection electrodes which are additionally arranged below the plane absorption net (7).

11. A method according to one of the claims 3 to 10,
characterized in
that the average beam flow of the primary electron beam occurring during the second part of the period of the absorption field is increased in comparison with the average intensity of the beam flow of the primary electron beam occurring during the first part of the period of the absorption field.

12. A method according to claim 11, characterized in
that, during the second part of the period of the absorption field, the primary electron beam is controlled in response to the shift of the potential of the insulating surface (4).

13. A method according to claim 3, characterized in
that, during the second part of the period, the absorption field voltage is controlled in response to the surface potential of the insulating surface (4) of the unit under measurement (5) in such a way that only part of the secondary electrons is retarded.

14. A device for contactless measurement of electric voltages in a unit under measurement (5) including an insulating surface (4) and at least one conducting zone (6) lying below said insulating surface (4), especially in an integrated circuit (5) having a passivated surface, comprising the following features:
- a primary beam generating device (2) directing within an evacuated measuring chamber (3) a primary electron beam onto the insulating surface (4) of the unit under measurement (5) above the conducting zone (6) which is to be measured with respect to its voltage;
- an absorption net (7), which is arranged above said unit under measurement (5) and which has applied thereto an absorption voltage by means of an absorption voltage source (8), said absorption voltage being used for generating an absorption field in the area above said unit under measurement (5); and
- a device (9) for measuring the energy of the electrons of a secondary electron flow generated at the insulating surface (4) of the unit under measurement (5),
characterized in
that the absorption voltage source (8) is an a.c. voltage source, the output voltage thereof alternating between a positive voltage and a negative voltage, wherein the value of the positive voltage is high when compared to the value of the negative voltage, and
that the measuring device (9) measures the energy of the electrons of the secondary electron flow in synchronization with that partial period of the a.c. voltage produced by the absorption voltage source (8), during which the high, positive voltage is applied.

15. A device according to claim 14, characterized in
that the absorption voltage source (8) is a square-wave voltage source.

16. A device according to claim 15, characterized in
that the period duration of the rectangular voltage signal generated by the absorption voltage source (8) is shorter than the charge reversal time constant for surface charges at the insulating surface (4) of the unit under measurement (5).

17. A device according to claim 15 or 16, characterized in
that the temporally rectangular voltage signal generated by the absorption voltage source (8) has, during a first part of the period, the high, positive voltage in comparison with the potential of conductive areas of the unit under measurement (5), and
that, during the second part of the period, the voltage signal has the low, negative voltage.

18. A device according to claim 17, characterized in
that the high, positive voltage lies between 1000 and 2000 volt, and
that the low, negative voltage lies between -1 and -100 volt.

19. A device according to one of the claims 14 to 18, characterized in
that the device (9) for measuring the energy of the electrons of the secondary electron flow is followed by a low pass (14), and
that the ratio of the rectangular voltage, which is generated by the absorption voltage source (8), is controlled in response to the output signal of said low pass (14) in such a way that a low, positive surface potential will occur at the insulating surface (4) of the unit under measurement (5).

## Revendications

1. Procédé pour la mesure sans contact de tensions électriques dans un objet à mesurer (5) comportant une surface isolante (4) et au moins une zone conductrice (6) située sous la surface isolante (4), en particulier dans un circuit intégré (5) à surface passivée, dans lequel:
- un faisceau électronique primaire est orienté, dans une chambre de mesure évacuée (3), sur la surface isolante (4) au-dessus de la zone conductrice (6) de l'objet à mesurer (5) quant à sa tension,
- un courant d'électrons secondaires est généré à la surface isolante (4) de l'objet à mesurer (5),
- un champ électrique d'absorption est généré au-dessus de l'objet à mesurer (5), et
- le potentiel de la zone conductrice (6) est déterminé par la mesure de l'énergie des électrons du courant d'électrons secondaires,
caractérisé en ce
que le champ électrique d'absorption est un champ alternatif qui alterne entre une tension positive et une tension négative, la tension positive étant élevée en valeur, comparée à la tension négative, et
que la mesure de l'énergie des électrons du courant d'électrons secondaires se fait de manière synchronisée avec la période partielle du champ alternatif pendant laquelle est présente la tension d'absorption positive élevée.

2. Procédé suivant la revendication 1, caractérisé en ce que le champ d'absorption présente une durée de période qui est inférieure à la constante de temps de transfert des charges superficielles de la surface isolante (4) de l'objet à mesurer (5).

3. Procédé suivant la revendication 1 ou 2, caractérisé en ce
que le champ d'absorption a une évolution temporelle rectangulaire,
que le champ d'absorption a, pendant une première partie de la période, une haute intensité de champ à polarité absorbant les électrons secondaires de la surface isolante (4) de l'objet à mesurer (5), et
que le champ d'absorption a, pendant la seconde partie de la période, une faible intensité de champ, comparée à l'intensité de champ pendant la première partie de la période, à polarité repoussant les électrons secondaires vers la surface isolante (4) de l'objet à mesurer (5).

4. Procédé suivant la revendication 3, caractérisé en ce que le rapport entre la première partie de la période et la seconde partie de la période est réglé en fonction du potentiel superficiel de la surface isolante (4) de l'objet à mesurer (5), de telle manière qu'il s'établit, à la moyenne temporelle, un faible potentiel superficiel à la surface isolante (4) de l'objet à mesurer (5).

5. Procédé suivant la revendication 4, caractérisé en ce que la valeur des potentiels superficiels moyens temporels est comprise entre zéro volt et dix volts.

6. Procédé suivant les revendications 3 ou 4, caractérisé en ce
que, pendant la première partie de la période du champ d'absorption, le faisceau électronique primaire est concentré, pour la mesure de la tension électrique dans l'objet à mesurer (5), sur la surface isolante (4) de celui-ci, et
que, pendant la seconde partie de la période, le faisceau électronique primaire est irradié, pour soutenir la compensation des charges superficielles formées pendant la phase de mesure sur la surface isolante (4), à plat sur celle-ci.

7. Procédé suivant la revendication 6, caractérisé en ce que la grandeur et la position de la surface isolante (4) irradiée pendant la seconde partie de la période du champ d'absorption peuvent être réglées par déviation en forme de trame du faisceau électronique primaire.

8. Procédé suivant les revendications 6 ou 7, caractérisé en ce que par le réglage de la durée de temporisation ou du courant ou de la surface de balayage du faisceau électronique primaire pendant la seconde partie de la période du champ d'absorption, il peut être créé une variation non-homogène locale du potentiel superficiel de la surface isolante (4), de manière que le point d'impact du faisceau électronique primaire en forme de point se trouve, pendant la première partie de la période, dans une zone dans laquelle les électrons secondaires sont retardés pendant la seconde partie de la période.

9. Procédé suivant la revendication 3, caractérisé en ce qu'il est procédé à une compensation des charges superficielles de la surface isolante (4) de l'objet à mesurer (5) en influençant les trajets de vol des électrons secondaires par la forme et/ou l'intensité du champ d'absorption pendant la seconde partie de la période, de telle manière que la zone irradiée pendant la première partie de la période par le faisceau électronique primaire est atteinte, pendant la seconde partie de la période, par un nombre suffisant d'électrons secondaires.

10. Procédé suivant la revendication 9, caractérisé en ce qu'il est procédé à la formation du champ d'absorption pendant la seconde partie de la période à l'aide d'un réseau d'absorption (7) de forme hémisphérique ou par des électrodes de déviation électrostatiques disposées en supplément sous un réseau d'absorption (7) plan.

11. Procédé suivant l'une des revendications 3 à 10, caractérisé en ce que le courant de faisceau moyen du faisceau électronique primaire pendant la seconde partie de la période du champ d'absorption est augmenté par rapport à l'intensité moyenne du courant de faisceau moyen du faisceau électronique primaire pendant la première partie de la période du champ d'absorption.

12. Procédé suivant la revendication 11, caractérisé en ce que le faisceau électronique primaire pendant la seconde partie de la période du champ d'absorption est réglé en fonction de la variation du potentiel de la surface isolante (4).

13. Procédé suivant la revendication 3, caractérisé en ce que la tension du champ d'absorption pendant la seconde partie est réglée en fonction du potentiel superficiel de la surface isolante (4), de manière qu'une partie seulement des électrons secondaires sont retardés.

14. Dispositif pour la mesure sans contact de tensions électriques dans un objet à mesurer (5) comportant une surface isolante (4) et au moins une zone conductrice (6) située sous la surface isolante (4), en particulier dans un circuit intégré (5) à surface passivée, aux caractéristiques suivantes:
- un dispositif de génération de faisceau primaire (2) qui, dans une chambre de mesure évacuée (3), dirige un faisceau électronique primaire sur la surface isolante (4) de l'objet à mesurer (5), au-dessus de sa zone conductrice (6) à mesurer quant à sa tension,
- un réseau d'absorption (7), disposé au-dessus de l'objet à mesurer (5), qui, à l'aide d'une source de tension d'absorption (8), est soumis à l'admission d'une tension d'absorption pour la génération d'un champs d'absorption dans la zone au-dessus de l'objet à mesurer (5), et
- un dispositif (9) de mesure de l'énergie des électrons d'un courant d'électrons secondaires généré à la surface isolante (4) de l'objet à mesurer (5),
caractérisé en ce
que la source de tension d'absorption (8) est une source de tension alternative dont la tension de sortie alterne entre une tension positive et une tension négative, la tension positive étant élevée en valeur, comparée à la tension négative, et
que le dispositif de mesure (9) mesure l'énergie des électrons du courant d'électrons secondaires de manière synchronisée avec la période partielle de la tension alternative générée par la source de tension d'absorption (8) pendant laquelle est présente la tension d'absorption positive élevée.

15. Dispositif suivant la revendication 14, caractérisé en ce que la source de tension d'absorption (8) est une source de tension rectangulaire.

16. Dispositif suivant la revendication 15, caractérisé en ce que la durée de la période du signal de tension rectangulaire généré par la source de tension d'absorption (8) est plus courte que la constante de temps de transfert des charges superficielles à la surface isolante (4) de l'objet à mesurer (5).

17. Dispositif suivant la revendication 15 ou 16, caractérisé en ce
que le signal de tension temporellement rectangulaire généré par la source de tension d'absorption (8) a, pendant une première partie de la période, la tension positive élevée par rapport au potentiel des zones conductrices de l'objet à mesurer (5), et
que le signal de tension pendant la seconde partie de la période présente la faible tension négative.

18. Dispositif suivant la revendication 17, caractérisé en ce
que la tension positive élevée est comprise entre 1000 et 2000 volts, et
que la faible tension négative est comprise entre -1 et -100 volts.

19. Dispositif suivant l'une des revendications 14 à 18, caractérisé en ce
que le dispositif (9) de mesure de l'énergie des électrons du courant d'électrons secondaires est connecté après un passe-bas (14), et
que le rapport de la tension rectangulaire générée par la source de tension d'absorption (8) est réglé en fonction du signal de sortie du passe-bas (14), de manière qu'il est établi, à la surface isolante (4) de l'objet à mesurer (5), un faible potentiel superficiel positif.
